# EUROPÄISCHE PATENTANMELDUNG

(11) **EP 1 536 466 A2**
(43) Veröffentlichungstag der Anmeldung: **01.06.2005**
(21) Anmeldenummer: 04026487.1
(22) Anmeldetag: 08.11.2004
(51) Int. Cl.: H01L 23/373

(54) **Trägerschicht für eine Halbleiterschichtenfolge und Verfahren zur Herstellung von Halbleiterchips**

(30) Priorität: 28.11.2003 DE 10355600
(71) Anmelder: Osram Opto Semiconductors GmbH, 93049 Regensburg (DE)
(72) Erfinder: Grötsch, Stefan, 93077 Lengfeld/Bad Abbach (DE); Illek, Stefan, 93093 Donaustauf (DE); Plössl, Andreas, 93053 Regensburg (DE); Hahn, Berthold, 93155 Hemau (DE)
(74) Vertreter: Epping, Hermann, Fischer

(57) **Zusammenfassung**

Gegenstand der Erfindung ist eine Trägerschicht (1) für eine Halbleiterschichtenfolge, die eine elektrische Isolationsschicht (2) umfasst, die eine Keramik oder AlN enthält. Weiterhin wird ein Verfahren zur Herstellung von Halbleiterchips angegeben.

## Beschreibung

Die vorliegende Erfindung betrifft eine Trägerschicht für eine Halbleiterschichtenfolge nach dem Oberbegriff des Anspruchs 1 oder 3. Weiterhin betrifft die Erfindung ein Verfahren zur Herstellung von Halbleiterchips nach dem Oberbegriff des Anspruchs 18 oder 19.

Als Trägerschicht wird im Rahmen der Erfindung eine Schicht angesehen, auf der die Halbleiterschichtenfolge im Laufe ihrer Prozessierung angeordnet wird. Insbesondere geschieht dies vor einer Vereinzelung in Halbleiterchips, die Halbleiterchipbereiche und diese wiederum einen Teil der Halbleiterschichtenfolge umfassen. Diese Halbleiterchips können nachfolgend für Halbleiterbauelemente weiterverarbeitet werden. Die Halbleiterschichtenfolge ist insbesondere zur Ausbildung einer Mehrzahl von Halbleiterchipbereichen vorgesehen. Von einem Aufwachssubstrat der oben erwähnten Halbleiterschichtenfolge ist die Trägerschicht in jedem Fall zu unterscheiden.

Eine derartige Trägerschicht sollte bezüglich ihrer Ausdehnungskoeffizienten gut an die Halbleiterschichtenfolge angepasst sein, um für die Halbleiterschichtenfolge schädliche Verspannungen bei Erwärmung zu vermeiden, und eine hohe Wärmeleitfähigkeit aufweisen, um eine gute Wärmeableitung aus der Halbleiterschichtenfolge, insbesondere dem späteren Halbleiterchip, zu gewährleisten. Für den Fall, dass die elektrische Kontaktierung der Halbleiterschichtenfolge über die Trägerschicht erfolgt, ist deren elektrische Leitfähigkeit entsprechend hoch zu wählen.

Bekannt sind beispielsweise Trägerschichten aus Halbleitermaterialien wie Ge oder GaAs sowie aus Metallen, wie Mo oder CuW.

Werden metallische Trägerschichten verwendet, die gewöhnlich eine hohe Wärmeleitfähigkeit besitzen, so kann beim Vereinzeln, das häufig durch Sägen erfolgt, die Gefahr erhöht werden, dass Metallspäne oder Verwerfungen am Metall entstehen, die den Halbleiterchip, beispielsweise durch einen Kurzschluß, unbrauchbar machen. Häufig ist auch der thermische Ausdehnungskoeffizient ungenügend an die Halbleiterschichtenfolge angepaßt und es können bei Erwärmung Verspannungen zwischen der Trägerschicht und der Halbleiterschichtenfolge entstehen, die sich schädlich auf die Halbleiterschichtenfolge auswirken.

Halbleitermaterialien dagegen besitzen gegenüber Metallen oftmals kleinere Wärme- oder elektrische Leitfähigkeiten und häufig eine geringere mechanische Stabilität, insbesondere hinsichtlich der Brüchigkeit, wodurch die Gefahr einer Schädigung der Halbleiterschichtenfolge und damit der späteren Halbleiterchips erhöht wird. Hinsichtlich der thermischen Ausdehnungskoeffizienten aber sind Halbleitermaterialien meist besser an die Halbleiterschichtenfolge angepasst als Metalle.

Weiterhin ist ein Chipträger aus einer elektrisch isolierenden AlN-Keramik bekannt, auf dem Halbleiterchips nach dem Vereinzeln angeordnet werden können. Diese Chipträger können eine Leiterstruktur aufweisen, die eine elektrische Kontaktierung des Halbleiterchips von der dem Chip gegenüberliegenden Seite des Chipträgers aus ermöglicht. Diese Leiterstruktur kann Durchkontaktierungen durch den Chipträger, sogenannte Vias umfassen, die mit Wolfram ausgefüllt sind. Derartige Chipträger zeichnen sich durch eine gute Wärmeleitfähigkeit aus. Hinsichtlich Ihrer Ausdehnungskoeffizienten können derartige Chipträger durch geeignete Prozessführung bei der Herstellung an die Halbleiterschichtenfolge angepasst werden. Da jedem einzelnen Chip ein derartiger Chipträger zugeordnet wird, ist die Produktion solcher Chips kosten- und zeitintensiv.

Aufgabe der vorliegenden Erfindung ist es, eine Trägerschicht für eine Halbleiterschichtenfolge der eingangs genannten Art anzugeben, mit einer verbesserten Anpassung hinsichtlich ihrer thermischen Eigenschaften, insbesondere des Ausdehnungskoeffizienten, an die Halbleiterschichtenfolge. Eine weitere Aufgabe der Erfindung ist die Entwicklung eines Herstellungsverfahrens für Halbleiterchips mit einer derartigen Trägerschicht.

Diese Aufgabe wird durch eine Trägerschicht nach den Anspruch 1 oder 3, sowie ein Verfahren nach Anspruch 18 oder 19 gelöst.

Eine erfindungsgemäße Trägerschicht für eine Halbleiterschichtenfolge umfasst gemäß einer ersten Ausführungsform eine elektrische Isolationsschicht, die AlN enthält. Das AlN ist dabei vorzugsweise als Keramik und/oder strahlungsundurchlässig ausgebildet.

Eine erfindungsgemäße Trägerschicht für eine Halbleiterschichtenfolge umfasst gemäß einer zweiten Ausführungsform eine elektrische Isolationsschicht, die eine Keramik enthält. Eine Keramik enthaltende Trägerschicht ist als Trägerschicht besonders geeignet. Bevorzugt enthält die Keramik ein Aluminiumnitrid oder ein Aluminiumoxid.

Die Halbleiterschichtenfolge ist beispielsweise auf einer ersten Hauptfläche der Trägerschicht angeordnet.

Es sei angemerkt, dass im Rahmen der vorliegenden Erfindung der Begriff Halbleiterschichtenfolge als allgemeine Abfolge von übereinander angeordneten Halbleiterschichten zu verstehen ist, wie zum Beispiel die Halbleiterschichten eines Halbleiterwafers, die beispielsweise epitaktisch auf einem Aufwachssubstrat gewachsen wurden.

Eine derartige Trägerschicht hat den Vorteil einer hohen Wärmeleitfähigkeit, die für eine AlN enthaltende Trägerschicht beispielsweise bis zu 230 W/mK betragen kann. Ferner wird die Gefahr, dass während des Vereinzelns ein Kurzschluss in den späteren Halbleiterchips verursacht wird, durch die elektrisch isolierende Keramik bzw. das elektrisch isolierende AlN zumindest stark verringert. Die thermischen Ausdehnungseigenschaften der Trägerschicht und der Halbleiterschichtenfolge sind, insbesondere zum Schutz vor Verspannungen, mit Vorteil aneinander angepasst. Dies kann zum Beispiel durch eine geeignete Prozessführung bei der Herstellung der Trägerschicht erreicht werden.

Weiterhin kann sich eine derartige Trägerschicht verglichen mit Trägerschichten aus Halbleitermaterialien wie Ge oder GaAs durch eine vorteilhaft hohe Stabilität auszeichnen. Die Trägerschicht ist hierzu bevorzugt freitragend ausgebildet, so dass sie ihr Eigengewicht und besonders bevorzugt auch die Halbleiterschichtenfolge mechanisch stabilisiert. Die Dicke der Isolationsschicht ist bevorzugt größer als 50 µm, besonders bevorzugt größer als 100 µm.

Die Halbleiterschichtenfolge kann mit der Trägerschicht über eine Verbindungsschicht die beispielsweise durch ein Lot, eutektisches Bonden mit geeigneten Metallschichten oder Kleben gebildet wird, verbunden sein. Diese Verbindung ist vorzugsweise elektrisch leitend ausgebildet.

In einer bevorzugten Ausgestaltung der Erfindung umfasst die Halbleiterschichtenfolge eine Strahlung erzeugende aktive Zone, beispielsweise einen pn-Übergang, eine Ein-.oder eine Mehrfach-Quantentopfstruktur. Die Halbleiterschichtenfolge kann dabei für LED-Chips, strahlungemittierende Halbleiterbauelemente mit Resonator, wie kantenemittierende Laser oder vertikalemittierende Bauelemente wie VCSEL, VECSEL oder RCLEDs ausgebildet sein. Bevorzugt liegt die Wellenlänge der erzeugten Strahlung im ultravioletten bis infraroten Spektralbereich.

Gerade bei den genannten Lasern ist die hohe Wärmeleitfähigkeit der Trägerschicht von Vorteil, da die in diesen Bauelementen entstehende Wärme gewöhnlich beträchtlich ist und mit Vorteil aus dem Bauelement abgeleitet wird, um dessen Funktion nicht zu beeinträchtigen. Mit besonderem Vorteil kann bei Lasern und auch bei den weiteren oben angeführten Bauelementen auf eine zusätzliche Wärmesenke verzichtet werden.

Die Halbleiterschichtenfolge enthält bevorzugt mindestens ein III-V-Halbleitermaterial, umfassend InₓGa_{y}Al_{1-x-y}P, InₓGa_{y}Al_{1-x-y}N oder InₓGa_{y}Al_{1-x-y}As, jeweils mit 0≤x≤1, 0≤y≤1 und x+y≤1. Besonders bevorzugt enthält die aktive Zone mindestens eines dieser Materialien.

In einer vorteilhaften Weiterbildung der Erfindung ist der aktiven Zone eine Spiegelschicht, beispielsweise zwischen der aktiven Zone und der ersten Hauptfläche der Trägerschicht, nachgeordnet. Diese kann zum Beispiel einen verteilten Braggspiegel, vorzugsweise in der Halbleiterschichtenfolge ausgebildet, und/oder eine Metallschicht, beispielsweise Au, Al, Ag, Pt oder Legierungen mit mindestens einem dieser Materialien enthaltend, umfassen. Die Spiegelschicht ist bevorzugt elektrisch leitend ausgebildet und/oder mit der Halbleiterschichtenfolge elektrisch leitend verbunden und kann Teil eines optischen Resonators, beispielsweise für ein vertikalemittierendes Bauelement, sein. Eine derartige Spiegelschicht erhöht mit Vorteil die Effizienz eines späteren Halbleiterchips.

In einer vorteilhaften Weiterbildung der Trägerschicht weist diese eine Leiterstruktur auf, die die erste Hauptfläche mit einer dieser gegenüberliegenden zweiten Hauptfläche elektrisch leitend verbindet und dadurch eine elektrische Kontaktierung der Halbleiterschichtenfolge über die zweite Hauptfläche der Trägerschicht ermöglicht.

Diese Leiterstruktur umfasst bevorzugt Aussparungen in der Trägerschicht, die von der ersten zur zweiten Hauptfläche reichen. In diesen Aussparungen ist vorzugsweise ein elektrisch leitendes Material, beispielsweise ein Metall wie etwa W, Cu, Ag oder Au oder eine Legierung mit mindestens einem dieser Materialien angeordnet, welches mit Vorzug mit der Halbleiterschichtenfolge elektrisch leitend verbunden ist.

Besonders bevorzugt ist das Material in der Aussparung, insbesondere bezüglich der mechanischen und thermischen Eigenschaften, gut an die Keramik oder das AlN angepasst. Mit Vorteil werden dadurch die Verspannungen, die zwischen der Isolationsschicht und dem Material in der Aussparung auftreten können verringert und die Stabilität der Trägerschicht mit der Leiterstruktur wird infolgedessen erhöht. W zum Beispiel erfüllt diese Bedingungen zumindest hinsichtlich des thermischen Ausdehnungskoeffizienten und bezüglich AlN. Eine derartige Trägerschicht aus AlN mit einer Leiterstruktur, die W enthält, kann, insbesondere bezüglich der Ausdehnungskoeffizienten, gut an die Halbleiterschichtenfolge angepasst sein. So wird die Gefahr einer Schädigung der Halbleiterschichtenfolge durch thermisch verursachte Verspannungen reduziert und weitergehend die elektrische Kontaktierung der Halbleiterschichtenfolge über die zweite Hauptfläche der Trägerschicht ermöglicht. Weiterhin kann auch die Wärmeleitfähigkeit mit beispielsweise 195 W/mK verglichen mit Trägerschichten aus Halbleitermaterialien vorteilhaft erhöht sein.

In einer vorteilhaften Weiterbildung der Leiterstruktur wird in diese ein zusätzlicher Wärmeleitstoff, beispielsweise in der Form von Diamantpartikeln, eingebracht, der bevorzugt in der Aussparung angeordnet ist und eine höhere Wärmeleitfähigkeit als das elektrisch leitende Material in der Aussparung aufweist. Dieser Wärmeleitstoff erhöht mit Vorteil die Wärmeleitfähigkeit der Leiterstruktur, insbesondere im Bereich der Aussparung, und in der Folge die der Trägerschicht, welche die Aussparungen umfasst. Weiterhin'kann der Wärmeleitstoff die Anpassung der mechanischen Eigenschaften des elektrisch leitenden Materials in der Aussparung an das der Isolationsschicht verbessern, da der Anteil an elektrisch leitendem Material in der Aussparung auf Kosten des Wärmeleitstoffes reduziert ist, der mit Vorteil dafür geeignete mechanische und thermische Eigenschaften aufweist.

In einem erfindungsgemäßen Verfahren zur Herstellung von Halbleiterchips mit einem Halbleiterchipbereich, der eine Strahlung erzeugende aktive Zone aufweist und auf einem Chipträger angeordnet ist, der gemäß einer ersten Ausführungsform eine Keramik oder gemäß einer zweiten Ausführungsform AlN enthält, wird zunächst eine Halbleiterschichtenfolge auf einem Substrat hergestellt, bevorzugt durch epitaktisches Aufwachsen auf einem Aufwachssubstrat. Nachfolgend wird die Halbleiterschichtenfolge auf einer eine Keramik bzw. AlN enthaltenden Trägerschicht angeordnet, woraufhin das Substrat entfernt wird.

Die Trägerschicht oder die Halbleiterschichtenfolge sind bevorzugt wie in den entsprechenden obigen Ausführungen ausgebildet, so dass die Trägerschicht beispielsweise eine Leiterstruktur umfasst oder die Trägerschicht und die Halbleiterschichtenfolge andere der dort genannten Merkmale aufweisen können. Auch weitere der obigen Ausführungen können entsprechend auf das Verfahren angewandt werden. So kann auf die Halbleiterschichtenfolge auf der dem Substrat abgewandten Seite vor der Anordnung auf der Trägerschicht beispielsweise eine metallische Spiegelschicht, bevorzugt durch Sputtern oder Aufdampfen, aufgebracht werden.

Von der der Trägerschicht gegenüberliegenden Seite her wird die Halbleiterschichtenfolge hierauf in vorzugsweise räumlich voneinander getrennte Halbleiterchipbereiche strukturiert und die Struktur aus Halbleiterchipbereichen und Trägerschicht, beispielsweise durch Sägen oder ein Lasertrennverfahren, derart in Halbleiterchips vereinzelt, dass die Halbleiterchips jeweils mindestens einen Halbleiterchipbereich umfassen. Die Vereinzelung erfolgt dabei vorzugsweise in den Zwischenräumen zwischen den Halbleiterchipbereichen. Der Halbleiterchip ist nach dem Vereinzeln auf einem Chipträger angeordnet, der eine Keramik bzw. AlN enthält, und beim Vereinzeln aus der Trägerschicht hervorgeht. Durch Entfernen des Aufwachssubstrats und Anordnung der Halbleiterschichtenfolge auf einer Trägerschicht hergestellte Halbleiterchips werden als Dünnfilm-Chips bezeichnet.

Die Strukturierung der Halbleiterschichtenfolge kann auch ganz oder teilweise erfolgen, während die Halbleiterschichtenfolge noch auf dem Substrat angeordnet ist, also vor der Anordnung auf dem Träger und ist nicht auf die Ausbildung der Halbleiterchipbereiche beschränkt. Vielmehr können auch Strukturen, die die Lichtauskopplung aus dem Halbleiterchip verbessern, den Chip vor schädlichen Einwirkungen schützen vorgesehen oder andere Prozesse während der Strukturierung durchgeführt werden.

Bevorzugt ist nach dem Vereinzeln im wesentlichen jeder Halbleiterchipbereich elektrisch leitend mit der Leiterstruktur verbunden.

Ein derartiges Herstellungsverfahren für Halbleiterchips hat den Vorteil, dass in einem durchgehenden Prozess Halbleiterchips hergestellt werden können, die auf einem eine Keramik bzw. AlN enthaltenden Chipträger angeordnet sind, der bezüglich des Ausdehnungskoeffizienten gut an die Halbleiterschichtenfolge angepasst ist und eine vorteilhaft hohe Wärmeleitfähigkeit aufweist. Insbesondere müssen die Chips nicht einzeln auf dem Chipträger angeordnet werden, da dieser beim Vereinzeln aus der Trägerschicht hervorgeht, wodurch die Produktionsdauer und -kosten derartiger Halbleiterchips reduziert werden.

Weitere Merkmale, Vorteile und Zweckmäßigkeiten der Erfindung ergeben sich aus den Beschreibungen der folgenden Ausführungsbeispiele in Verbindung mit den Figuren.

Es zeigen
Figur 1 in Figur 1A eine schematische Schnittansicht eines Teiles eines Ausführungsbeispiels einer erfindungsgemäßen Trägerschicht und in Figur 1B eine Aufsicht auf einen Teil eines Ausführungsbeispiels einer erfindungsgemäßen Trägerschicht;
Figur 2 in den Figuren 2A bis 2F eine schematische Darstellung eines Ausführungsbeispiels eines erfindungsgemäßen Verfahrens zur Herstellung eines Halbleiterchips, anhand von Zwischenschritten;

Gleichartige und gleich wirkende Elemente besitzen in den Figuren gleiche Bezugszeichen.

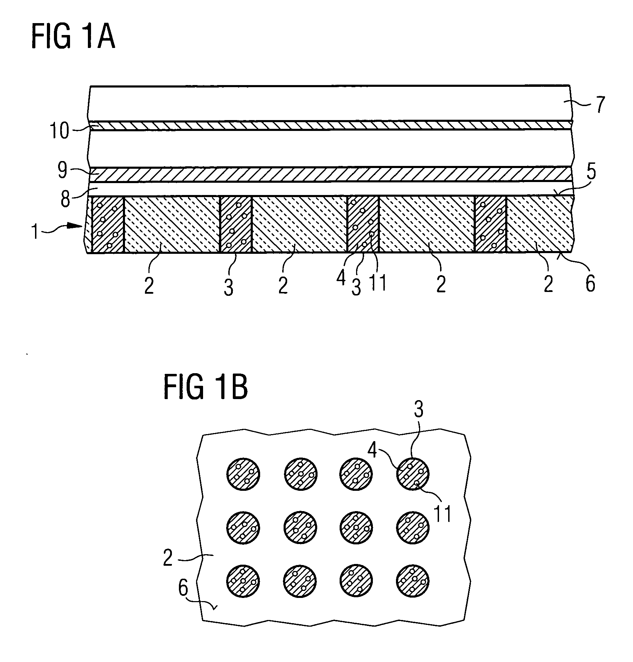

Figur 1A zeigt eine schematische Schnittansicht eines Teiles eines ersten Ausführungsbeispiels einer erfindungsgemäßen Trägerschicht.

Die Trägerschicht 1 umfasst eine Isolationsschicht 2, die AlN, insbesondere eine AlN-Keramik, enthält, von beispielsweise 200µm Dicke. In der Isolationsschicht 2 sind Aussparungen 3 vorgesehen, in denen ein elektrisches Leitermaterial 4, beispielsweise W, derart angeordnet ist, dass eine erste Hauptfläche 5 der Trägerschicht 1 mit einer zweiten Hauptfläche 6 elektrisch leitend verbunden ist. Der Trägerschicht 1 nachgeordnet ist eine Halbleiterschichtenfolge 7, die mit der Trägerschicht 1 über eine Verbindungsschicht 8 und eine Spiegelschicht 9 verbunden ist. Die Verbindungsschicht 8 ist elektrisch leitend, zum Beispiel als Lot, ausgebildet, so dass die Strahlung erzeugende aktive Zone 10 der Halbleiterschichtenfolge 7 über die elektrisch leitende Spiegelschicht 9 leitend mit dem Leitermaterial 4 verbunden ist.

Die Trägerschicht 1 ist freitragend ausgebildet, stabilisiert die Halbleiterschichtenfolge 7 mechanisch und gewährleistet die elektrische Kontaktierbarkeit der Halbleiterschichtenfolge 7 über die Aussparungen 4 von der zweiten Hauptfläche 6 her. Weiterhin weist die Trägerschicht 1, mit W in den Aussparungen, eine hohe Wärmeleitfähigkeit, von beispielsweise 195 W/mK, auf, die durch Einbringen eines Wärmeleitstoffes 11, beispielsweise Diamantpartikeln, in das elektrische Leitermaterial 4 in der Aussparung 3 noch erhöht wird. Auch kann die Trägerschicht 1 insbesondere durch die Prozessführung bei der Herstellung der Isolationsschicht 2 derart an die thermischen Ausdehnungskoeffizienten der Halbleiterschichtenfolge angepasst werden, dass diese verglichen mit metallischen Trägerschichten verbessert ist. Ferner weist eine derartige Trägerschicht eine zumindest im Bereich der Aussparungen 4 verglichen mit den meisten Halbleitermaterialien erhöhte elektrische und Wärmeleitfähigkeit auf.

Die Halbleiterschichtenfolge 7 kann hierbei für LED-Chips, strahlungemittierende Halbleiterbauelemente mit Resonator, wie kantenemittierende Laser oder vertikalemittierende Bauelemente wie VCSEL, VECSEL oder RCLEDs ausgebildet sein und die Spiegelschicht 9 beispielsweise eine Metallschicht oder einen verteilten Braggspiegel umfassen, der in der Halbleiterschichtenfolge 7 ausgebildet sein kann.

In der Figur 1B ist eine Aufsicht auf einen Teil eines Ausführungsbeispiel einer erfindungsgemäßen Trägerschicht dargestellt.

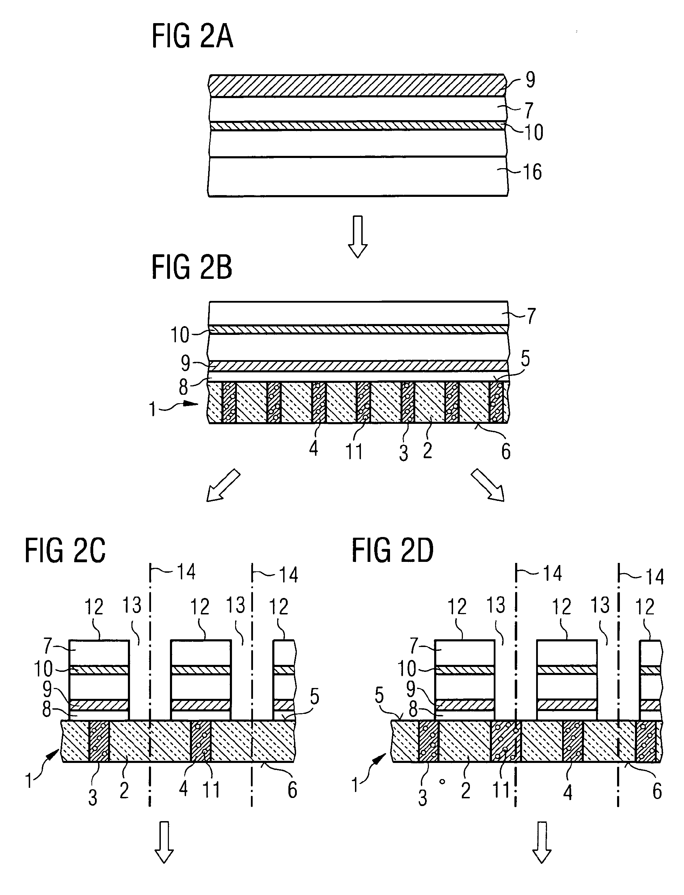

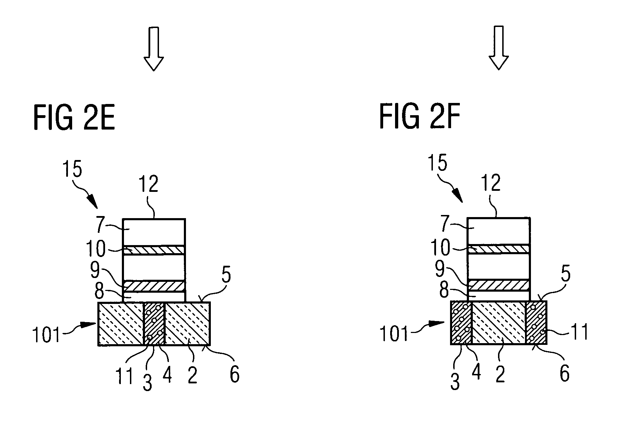

Gezeigt ist ein Teil einer Aufsicht auf die zweite Hauptfläche 6 einer Trägerschicht 1, wie etwa derjenigen aus Figur 1A. Die Aussparungen 3 in der Isolationsschicht 2 mit dem Leitermaterial 4 und dem Wärmeleitstoff 11 sind in diesem Ausführungsbeispiel in einem regelmäßigen Raster angeordnet, das sich für die weitere Prozessierung, insbesondere bei der Herstellung von Halbleiterchips unter Verwendung einer derartigen Trägerschicht 1 (vergleiche Figur 2 und die zugehörige Beschreibung) als vorteilhaft erweist und weisen in der Aufsicht beispielsweise einen kreisförmigen Querschnitt auf. In der Figur 1B ist als regelmäßiges Raster exemplarisch ein quadratisches Gitter dargestellt, an dessen Gitterpunkten jeweils eine Aussparung 3 angeordnet ist.

Die Aussparungen 3 werden zur Herstellung einer derartigen Trägerschicht beispielsweise in das noch weiche AlN-Material ("Green Sheet") gestanzt. Die eingesetzten Werkzeuge bestimmen hierbei die Form des Querschnitts der Aussparungen.

Hierauf kann in einer ersten Ausführungsform eine W-Paste als Leitermaterial 4 und der Wärmeleitstoff 11 in die Aussparung 3 eingebracht werden. Nachfolgend wird die Trägerschicht 1 durch Sintern fertig gestellt und die Halbleiterschichtenfolge 7 kann wie in Figur 1A dargestellt auf der Trägerschicht 1 angeordnet werden.

In einer zweiten Ausführungsform wird das AlN-Material nach der Herstellung der Aussparungen 3 gesintert und nachfolgend die Halbleiterschichtenfolge 7 auf dem AlN-Material angeordnet. Das Leitermaterial 4 kann daraufhin durch einen galvanischen Vorgang in die Aussparungen 3 eingebracht werden. Dieser Prozess kann mit Vorteil bei für die Halbleiterschichtenfolge 7 unschädlichen Temperaturen durchgeführt werden. Bevorzugt wird hierzu ein Leitermaterial 4 verwendet, das Ag oder Cu enthält.

Figur 2 zeigt eine schematische Darstellung eines Ausführungsbeispiels eines erfindungsgemäßen Verfahrens zur Herstellung eines Halbleiterchips, anhand von in den Figuren 2A bis 2F dargestellten Zwischenschritten.

In diesem Ausführungsbeispiel wird die Herstellung eines LED-Dünnfilm-Chips mit einer Spiegelschicht beschrieben. Das dargestellte Verfahren kann aber entsprechend für Chips angewandt werden, die für LEDs, RCLEDs sowie für Laser wie VCSEL, VECSEL oder kantenemittierende Laser oder für andersartige Halbleiterchips ausgebildet sind.

Eine auf einem Aufwachssubstrat 16 epitaktisch gewachsene Halbleiterschichtenfolge 7, beispielsweise InₓGa_{y}Al_{1-x-y}P oder InₓGa_{y}Al_{1-x-y}N enthaltend, mit einer Strahlung erzeugenden aktiven Zone 10 wird in Figur 2A in einem ersten Zwischenschritt mit einer Spiegelschicht 9 versehen. Für InₓGa_{y}Al_{1-x-y}P ist das Aufwachssubstrat 16 vorzugsweise aus GaAs und die Spiegelschicht aus Au, für InₓGa_{y}Al_{1-x-y}N sind zum Beispiel Saphir oder SiC als Aufwachssubstrate und Ag oder Al als Material für die Spiegelschicht geeignet. Die, insbesondere metallhaltige, Spiegelschicht 9 wird bevorzugt durch Sputtern oder Aufdampfen auf die dem Aufwachssubstrat 16 abgewandte Seite der Halbleiterschichtenfölge 7 aufgebracht.

Nachfolgend wird die Spiegelschicht 9 über eine elektrisch leitende Verbindungsschicht 8, beispielsweise ein Lot, auf einer ersten Hauptfläche 5 der Trägerschicht 1 befestigt. Die Trägerschicht 1 weist eine elektrische Isolationsschicht 2 aus AlN, insbesondere einer AlN-Keramik auf, in der Aussparungen 3 vorgesehen sind, in denen ein Leitermaterial 4, beispielsweise W angeordnet ist, in welchem wiederum ein Wärmeleitstoff 11, zum Beispiel in Form von Diamantpartikeln, angeordnet ist. Die Leiterstruktur, welche die Aussparungen 3 mit dem Leitermaterial 4 umfasst, erlaubt eine elektrische Kontaktierung der Halbleiterschichtenfolge 7 von einer der ersten Hauptfläche 5 gegenüberliegenden zweiten Hauptfläche 6 der Trägerschicht 1 aus. Der elektrische Kontakt erfolgt über das Leitermaterial 4, das über die leitende Verbindungsschicht 8 und die Spiegelschicht 9 elektrisch leitend mit der Halbleiterschichtenfolge 7 verbunden ist.

Daraufhin wird das Aufwachssubstrat 16 vorzugsweise durch Ätzen, mechanische Belastung oder ein Laserablöseverfahren entfernt, woraus die in Figur 2B gezeigte Struktur mit Trägerschicht 1 und der auf dieser angeordneten Halbleiterschichtenfolge 7 hervorgeht.

Eine derartige Trägerschicht ist besonders für die Verwendung bei Halbleiterschichtenfolgen geeignet, die InₓGa_{y}Al_{1-x-y}P oder InₓGa_{y}Al_{1-x-y}N enthalten, da AlN mit ungefähr 4.4 ppm/°C einen thermischen Ausdehnungskoeffizienten aufweist, der gut an diejenigen der Aufwachssubstrate GaAs beziehungsweise Saphir angepasst ist, die ungefähr 6 beziehungsweise 4.5 ppm/°C betragen. Ferner ist auch die Wärmeleitfähigkeit einer erfindungsgemäßen Trägerschicht mit etwa 195 W/mK verglichen mit Trägerschichten aus Halbleitermaterialien wie beispielsweise GaAs, das eine Wärmeleitfähigkeit von ungefähr 55 W/mK aufweist, vorteilhaft erhöht.

In einem weitergehenden Verfahrensschritt wird die Halbleiterschichtenfolge 7, beispielsweise durch Maskierungs- und Ätztechniken, derart in Halbleiterchipbereiche 12 strukturiert, dass diese durch Zwischenräume 13 räumlich voneinander getrennt sind. Ferner können die Halbleiterchipbereiche 12 mit Strahlungsauskoppel-, Passivierungs- oder Schutzstrukturen versehen werden, die mit Vorteil, die Strahlungsauskopplung aus dem späteren Halbleiterchip erhöhen oder den Chip vor schädlichen Einwirkungen schützen. Die Strukturierung kann auch ganz oder teilweise erfolgen, während die Halbleiterschichtenfolge 7 noch auf dem Aufwachssubstrat 16 angeordnet ist.

Die Figuren 2C und 2D zeigen die auf der Trägerschicht 1 angeordneten Halbleiterchipbereiche 12 nach dem obigen Strukturierungsprozess.

In Figur 2C ist im Bereich der Zwischenräume 13 im Gegensatz zu Figur 2D kein Leitermaterial 4 angeordnet.

Die in Figur 2C dargestellte Anordnung erfordert deshalb einen hohen Justieraufwand, entweder beim Strukturieren der Halbleiterschichtenfolge 7 auf der Trägerschicht 1 oder beim Anordnen der bereits teilweise oder vollständig strukturierten Halbleiterschichtenfolge 7 auf der Trägerschicht 1. Insbesondere müssen auch die Aussparungen 3 in der Trägerschicht 1 bei deren Herstellung der Größe eines späteren Halbleiterchips entsprechend angeordnet werden. Der Vorteil einer derartigen Anordnung des Leitermaterials 4 ist, dass die Vereinzelung der dargestellten Struktur, beispielsweise durch Sägen, entlang der Trennlinien 14 in Halbleiterchips 15, wie in der Figur 2E dargestellt, nur im elektrisch isolierenden AlN erfolgt. Hierdurch wird die Gefahr eines schädigenden Kurzschlusses der aktiven Zone 10 des Halbleiterchips durch beim Vereinzeln entstehende Späne des Leitermaterials 4 zumindest stark verringert. Bevorzugt ist so jedem Halbleiterchipbereich 12 mindestens eine Aussparung 3 mit dem Leitermaterial 4 zugeordnet, die vom Halbleiterchipbereich 12 vollständig überdeckt wird.

In der in Figur 2D gezeigten Anordnung ist im Bereich mancher Zwischenräume 13 Leitermaterial 4 angeordnet. Dies hat den Vorteil eines verglichen mit der Anordnung in Figur 2C geringeren nötigen Justieraufwands. Bei der Strukturierung der Halbleiterschichtenfolge 7 beziehungsweise der Anordnung auf der Trägerschicht 1 ist lediglich darauf zu achten, dass im wesentlichen jeder Halbleiterchipbereich 2 mit dem Leitermaterial verbunden ist. Dies kann beispielsweise über eine entsprechend hohe Dichte von Aussparungen 3 mit Leitermaterial 4 in der Isolationsschicht 3 erreicht werden.

Wird im folgenden entlang der Trennlinien 14 in Halbleiterchips 15, wie in Figur 2F dargestellt, vereinzelt, so geschieht dies zumindest teilweise im Leitermaterial 4, wodurch die Gefahr eines Kurzschlusses der aktiven Zone 10 erhöht werden kann. Ist das Leitermaterial 4 aber beispielsweise W, welches eine hohe Härte aufweist, kann die Bildung von W-Spänen beim Vereinzeln, beispielsweise durch Sägen, reduziert werden, was die Gefahr eines Kurzschlusses wiederum verringert. Beim Sägen im Wolfram kann das "Sägeblatt" allerdings abstumpfen, was durch das Sägen in der AlN-Keramik wieder kompensiert werden kann, da zum Schärfen der "Sägeblätter" häufig Keramiken benutzt werden.

Die in den Figuren 2E und 2F dargestellten Halbleiterchips 15 umfassen jeweils einen Halbleiterchipbereich 12, der auf einem Chipträger 101 angeordnet ist, welcher beim Vereinzeln aus der Trägerschicht 1 hervorgeht. Die Halbleiterchipbereiche 12 sind über das Leitermaterial 4 von der zweiten Hauptfläche 6 her elektrisch kontaktierbar und der Chipträger 101 gewährleistet eine gute Wärmeableitung aus dem Halbleiterchipbereich 12. Die Spiegelschicht 9 reflektiert die in der aktiven Zone 10 erzeugte Strahlung und steigert so die Effizienz des Halbleiterchips 15.

Ein derartiges Herstellungsverfahren für Halbleiterchips hat den Vorteil, dass die AlN enthaltende Trägerschicht im Verbund mit der Halbleiterschichtenfolge prozessiert werden kann. Somit muss nicht jeder einzelne Halbleiterchip 15 mit einem derartigen Chipträger 101 ausgestattet werden, wodurch die Produktionskosten und die benötigte Produktionszeit für Halbleiterchips auf einem derartigen Chipträger verringert werden.

Ferner kann wegen der hohen Wärmeleitfähigkeit der Trägerschicht mit Vorteil auf eine zusätzliche Wärmesenke verzichtet werden. Um die Wärmekapazität des Chipträgers 101 zu erhöhen, kann dessen Volumen beispielsweise durch größere Zwischenräume 13 oder eine dickere Trägerschicht 1 erhöht werden.

Die vorliegende Patentanmeldung beansprucht die Priorität der deutschen Patentanmeldung DE 103 55 600.1 vom 28. November 2003, deren gesamter Offenbarungsgehalt hiermit explizit durch Rückbezug in die vorliegende Patentanmeldung aufgenommen wird.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Trägerschicht (1) für eine Halbleiterschichtenfolge (7), wobei die Trägerschicht (1) eine elektrische Isolationsschicht (2) umfasst,
**dadurch gekennzeichnet, daß**
die Isolationsschicht (2) AlN enthält.

2. Trägerschicht nach Anspruch 1,
**dadurch gekennzeichnet, daß**
die Isolationsschicht (2) eine AlN-Keramik enthält.

3. Trägerschicht (1) für eine Halbleiterschichtenfolge (7), wobei die Trägerschicht (1) eine elektrische Isolationsschicht (2) umfasst,
**dadurch gekennzeichnet, daß**
die Isolationsschicht (2) eine Keramik enthält.

4. Trägerschicht (1) nach einem der vorgehenden Ansprüche,
**dadurch gekennzeichnet, daß**
die Isolationsschicht (2) freitragend ausgebildet ist.

5. Trägerschicht (1) nach einem der vorgehenden Ansprüche,
**dadurch gekennzeichnet, daß**
die Trägerschicht (1) eine Leiterstruktur aufweist.

6. Trägerschicht (1) nach Anspruch 5,
**dadurch gekennzeichnet, daß**
die Trägerschicht (1) eine erste und eine zweite Hauptfläche aufweist und sich die Leiterstruktur von der ersten (5) zur zweiten Hauptfläche (6) erstreckt.

7. Trägerschicht (1) nach Anspruch 5 oder 6,
**dadurch gekennzeichnet, daß**
die Leiterstruktur zumindest teilweise in Aussparungen (3) der Isolationsschicht (2) ausgebildet ist, die von der ersten zur zweiten Hauptfläche der Trägerschicht (1) reichen.

8. Trägerschicht (1) nach einem der Ansprüche 5 bis 7,
**dadurch gekennzeichnet, daß**
die Halbleiterschichtenfolge (7) elektrisch leitend mit der Leiterstruktur verbunden ist.

9. Trägerschicht (1) nach einem der Ansprüche 5 bis 8,
**dadurch gekennzeichnet, daß**
die Leiterstruktur ein Metall enthält.

10. Trägerschicht (1) nach Anspruch 9,
**dadurch gekennzeichnet, daß**
die Leiterstruktur W, Ag, Au, Cu oder eine Legierung mit mindestens einem dieser Materialien enthält.

11. Trägerschicht (1) einem der Ansprüche 5 bis 10,
**dadurch gekennzeichnet, daß**
in die Leiterstruktur zumindest teilweise ein Wärmeleitstoff (11) zur Erhöhung der Wärmeleitfähigkeit eingebracht ist.

12. Trägerschicht (1) nach einem der vorhergehenden Ansprüche,
**dadurch gekennzeichnet, daß**
die Halbleiterschichtenfolge (7) eine Strahlung erzeugende aktive Zone (10) aufweist.

13. Trägerschicht (1) nach Anspruch 12,
**dadurch gekennzeichnet, daß**
der aktiven Zone (10) eine Spiegelschicht (9) nachgeordnet ist.

14. Trägerschicht (1) nach Anspruch 13,
**dadurch gekennzeichnet, daß**
die Spiegelschicht (9) mit der Halbleiterschichtenfolge (7) elektrisch leitend verbunden ist.

15. Trägerschicht (1) nach Anspruch 13 oder 14,
**dadurch gekennzeichnet, daß**
die Spiegelschicht (9) zwischen der ersten Hauptfläche der Trägerschicht (1) und der aktiven Zone (10) angeordnet ist.

16. Trägerschicht (1) nach mindestens einem der vorhergehenden Ansprüche,
**dadurch gekennzeichnet, daß**
die Halbleiterschichtenfolge für LED-Chips oder strahlungemittierende Bauelemente mit Resonator, insbesondere kantenemittierende Laser oder vertikalemittierende Bauelemente, umfassend VCSEL, VECSEL und RCLEDs ausgebildet ist.

17. Trägerschicht (1) nach mindestens einem der vorhergehenden Ansprüche,
**dadurch gekennzeichnet, daß**
die Halbleiterschichtenfolge (7) mindestens ein III-V-Halbleitermaterial, umfassend InₓGa_{y}Al_{1-x-y}P, InₓGa_{y}Al_{1-x-y}N oder InₓGa_{y}Al_{1-x-y}As, jeweils mit 0≤x≤1, 0≤y≤1 und x+y≤1, enthält.

18. Verfahren zur Herstellung von Halbleiterchips (15) mit einem Halbleiterchipbereich (12), der eine Strahlung erzeugende aktive Zone (10) aufweist und auf einem Chipträger (101) angeordnet ist, der AlN enthält,
**gekennzeichnet durch** die Schritte,
- Bereitstellen einer Halbleiterschichtenfolge (7) mit der Strahlung emittierenden aktiven Zone auf einem Substrat (16),
- Verbinden der Halbleiterschichtenfolge (7) mit einer Trägerschicht (1), die AlN enthält,
- Entfernen des Substrats (16),
- Strukturieren der Halbleiterschichtenfolge (7) in Halbleiterchipbereiche (12),
- Vereinzeln der Struktur mit Halbleiterchipbereichen (12)
und Trägerschicht (1) in Halbleiterchips (15), die jeweils mindestens einen Halbleiterchipbereich (12) umfassen und auf einem Chipträger (101) angeordnet sind, der **durch** das Vereinzeln aus der Trägerschicht (1) hervorgeht.

19. Verfahren zur Herstellung von Halbleiterchips (15) mit einem Halbleiterchipbereich (12), der eine Strahlung erzeugende aktive Zone (10) aufweist und auf einem Chipträger (101) angeordnet ist, der eine Keramik enthält, **gekennzeichnet durch** die Schritte,
- Bereitstellen einer Halbleiterschichtenfolge (7) mit der Strahlung emittierenden aktiven Zone auf einem Substrat (16),
- Verbinden der Halbleiterschichtenfolge (7) mit einer Trägerschicht (1), die eine Keramik enthält,
- Entfernen des Substrats (16),
- Strukturieren der Halbleiterschichtenfolge (7) in Halbleiterchipbereiche (12),
- Vereinzeln der Struktur mit Halbleiterchipbereichen (12)
und Trägerschicht (1) in Halbleiterchips (15), die jeweils mindestens einen Halbleiterchipbereich (12) umfassen und auf einem Chipträger (101) angeordnet sind, der **durch** das Vereinzeln aus der Trägerschicht (1) hervorgeht.

20. Verfahren nach Anspruch 18 oder 19,
**dadurch gekennzeichnet, daß**
die Trägerschicht (1) eine Leiterstruktur aufweist.

21. Verfahren nach mindestens einem der vorhergehenden Ansprüche,
**dadurch gekennzeichnet, daß**
die Trägerschicht (1) eine erste (5) und eine zweite Hauptfläche (7) aufweist und sich die Leiterstruktur von der ersten zur zweiten Hauptfläche erstreckt.

22. Verfahren nach mindestens einem der vorhergehenden Ansprüche,
**dadurch gekennzeichnet, daß**
die Leiterstruktur elektrisch leitend mit der Halbleiterschichtenfolge (7) verbunden ist.

23. Verfahren nach mindestens einem der vorhergehenden Ansprüche,
**dadurch gekennzeichnet, daß**
zwischen der Trägerschicht (1) und der Halbleiterschichtenfolge (7) eine Spiegelschicht (9) angeordnet ist.

24. Verfahren nach mindestens einem der vorhergehenden Ansprüche,
**dadurch gekennzeichnet, daß**
die Leiterstruktur so geartet ist, dass im wesentlichen jeder Halbleiterchip (15) nach dem Vereinzeln elektrisch leitend mit der Leiterstruktur verbunden ist.
